# EUROPEAN PATENT SPECIFICATION

(11) **EP 3 416 199 B1**
(45) Date of publication and mention of the grant of the patent: **06.08.2025**
(21) Application number: 18176224.6
(22) Date of filing: 06.06.2018
(51) Int. Cl.: H01L 31/042, H01L 31/05, H01L 31/044

(54) **SOLAR CELL ARRAY WITH BYPASSED SOLAR CELLS**
SOLARZELLENANORDNUNG MIT ÜBERBRÜCKTEN SOLARZELLEN
RÉSEAU DE CELLULES SOLAIRES COMPORTANT DES CELLULES SOLAIRES COURT-CIRCUITÉES

(30) Priority: 12.06.2017 US 201762518131 P; 18.10.2017 US 201715787304
(43) Date of publication of application: 19.12.2018
(73) Proprietor: The Boeing Company, Arlington, VA 22202 (US)
(72) Inventor: Rehder, Eric, Chicago, IL 60606-1596 (US)
(74) Representative: Witte, Weller & Partner Patentanwälte mbB

(56) References cited:
- EP-A1- 3 297 042
- EP-A2- 1 160 876
- US-A1- 2011 079 263
- US-A1- 2017 018 670

## Description

### 1. Field.

The disclosure is related generally to solar cell panels and more specifically to a solar cell array with bypassed solar cells.

### 2. Background.

A typical spaceflight-capable solar cell panel assembly involves building solar cell arrays comprised of long strings of solar cells connected in series. These strings are variable in length, i.e., number of solar cells, and can be very long.

Conventional solar cell arrays are built with a fixed number of solar cells to produce a required output voltage. For example, a string of 50 solar cells connected in series may produce an output voltage of 100V. A failure of one or more of the solar cells in the string can greatly compromise the power delivered by all 50 solar cells.

This results in extensive efforts to test, validate, and qualify materials and processes to ensure a maximum lifetime and success of solar cell arrays. However, such efforts result in increased costs and decreased innovation. Moreover, the risks of some missions are too high and are avoided altogether.

What is needed, then, is a means for accommodating failures in the solar cell array's operation or where the expected output voltage is otherwise not being delivered during its lifespan.

Document EP 1 160 876 A2, according to its abstract, relates to a reconfigurable solar panel system having a plurality of solar cells arranged in a predefined pattern on a printed circuit board has a predefined pattern of interconnection paths to form at least one solar cell module. The solar panel being made of at least one solar cell module has the capability to be configured and reconfigured by programming at least one integrated circuit that communicates with each and every solar cell on the solar module.

Document US 2017/018670 A1, according to its abstract, relates to a photovoltaic module with a back side conductive substrate and a plurality of PV-cells having back contacts and being arranged in an array on a top surface of the back side conductive substrate. A circuit of series and/or parallel connected PV-cells is formed by connections between the back contacts and the back side conductive substrate. A plurality of by-pass diodes are present having back contacts in electrical contact with the circuit of series and/or parallel connected PV-cells, wherein the by-pass diodes are positioned on empty parts of the top surface of the back side conductive substrate. Each by-pass diode is a wafer based diode and is connected in parallel with one or more PV-cells.

Document US 2011/079263 A1, according to its abstract, relates to systems and methods for efficiently allowing current to bypass a group of solar cells having one or more malfunctioning or shaded solar cells without overwhelming a bypass diode. This can be done using a switch (e.g., a MOSFET) connected in parallel with the bypass diode. By turning the switch on and off, a majority of the bypass current can be routed through the switch, which is configured to handle larger currents than the bypass diode is designed for, leaving only a minority of the current to pass through the bypass diode.

### SUMMARY

According to the present disclosure, a solar cell array, a method of operating a solar cell array, and a method for fabricating a solar cell array as defined in the independent claims are provided. Further embodiments of the invention are defined in the dependent claims. Although the invention is only defined by the claims, the below embodiments, examples, and aspects are present for aiding in understanding the background and advantages of the invention.

An example of the present disclosure describes a solar cell array, method and device, comprising: one or more solar cells attached to a substrate, wherein: the substrate includes one or more electrical connections to the solar cells; and the substrate includes one or more switches for bypassing one or more of the electrical connections to one or more of the solar cells.

An area of the substrate remains exposed when at least one of the solar cells having one or more cropped corners is attached to the substrate; and the area of the substrate that remains exposed includes at least one of the switches. The at least one of the solar cells are attached to the substrate such that a corner region defined by the cropped corners of adjacent ones of the at least one of the solar cells are aligned, thereby exposing the area of the substrate. At least one of the switches is located in the corner region defined by the cropped corners adjacent to the at least one of the solar cells.

The solar cells, one or more bypass diodes, and the switches are electrically connected in parallel. Moreover, the switches are controlled by one or more control signals.

The switches bypass current around the one or more of the solar cells. Specifically, the switches, when closed, connect front and back contacts of the one or more of the solar cells, so that current bypasses the one or more of the solar cells.

There are also switches for adding or removing one or more of the solar cells to or from a string of the solar cells, wherein the string's length is altered to change a voltage produced by the string.

### DRAWINGS

Referring now to the drawings in which like reference numbers represent corresponding parts throughout:
FIGS. 1 and 2 illustrate conventional structures for solar cell panels.
FIGS. 3A and 3B illustrate an improved structure for a solar cell panel, according to one example.
FIGS. 4A and 4B illustrate an alternative structure for the solar cell panel, according to one example.
FIG. 5 illustrates the front side of an exemplary solar cell that may be used in the improved solar cell panel of FIGS. 3A-3B and 4A-3B.
FIG. 6 illustrates the back side of the exemplary solar cell of FIG. 5.
FIG. 7 illustrates cells arranged into the two-dimensional (2D) grid of the array, according to one example.
FIG. 8 illustrates an example of the array where one or more bypass diodes are added to the exposed area of the substrate in the corner regions.
FIG. 9 illustrates an example where the bypass diode is applied to the back side of the cell, with an interconnect or contact for the bypass diode extending into the corner region between front and back contacts.
FIG. 10 illustrates a front side view of the example of FIG. 9, with the interconnect or contact for the bypass diode extending into the corner region between the front and back contacts.
FIG. 11 illustrates the cells of FIGS. 9 and 10 arranged into the 2D grid of the array and applied to the substrate, where the bypass diodes are applied to the back side of the cells, with the contacts for the bypass diodes extending into the corner regions of the cells.
FIG. 12 shows up/down series connections between the cells of the array, according to one example.
FIG. 13 shows left/right series connections between the cells of the array, according to one example.
FIG. 14 shows is a circuit diagram of a string comprised of two solar cells with multiple switches and connections paths illustrated.
FIG. 15 shows how solar cell bypassing involves a single bypass switch that connects the front and backside contacts of the solar cell.
FIG. 16 shows a set of three solar cells in a vertical column.
FIG. 17 illustrates a single integrated device combining the switch functions with a bypass diode.
FIG. 18 illustrates combined switches adjacent to a bypass diode.
FIG. 19 describes a method of fabricating a solar cell, solar cell panel and/or satellite, according to one example.
FIG. 20 illustrates a resulting satellite having a solar cell panel comprised of solar cells, according to one example.

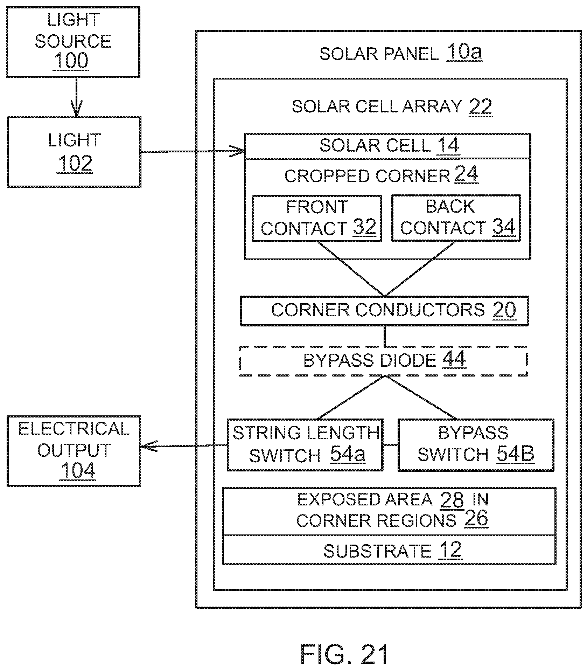

FIG. 21 is an illustration of the solar cell panel in the form of a functional block diagram, according to one example.
FIGS. 22A-22H illustrate experimental results, where a solar cell array based on the corner conductor design and using a flex circuit substrate was built to demonstrate the reconfiguration of the string length of the array.

### DETAILED DESCRIPTION

In the following description, reference is made to the accompanying drawings which form a part hereof, and in which is shown by way of illustration a specific example in which the disclosure may be practiced. It is to be understood that other examples may be utilized and structural changes may be made without departing from the scope of the present disclosure.

### GENERAL DESCRIPTION

A new approach to the design of solar cell arrays, such as those used for spaceflight power applications, is based on electrical connections among the solar cells in the array.

This new approach rearranges the components of a solar cell and the arrangements of the solar cells in the array. Instead of having solar cells connected into long linear strings and then assembled onto a substrate, the solar cells are attached individually to a substrate, such that corner regions of adjacent cells are aligned on the substrate, thereby exposing an area of the substrate. Electrical connections between cells are made by corner conductors formed on or in the substrate in these corner regions. Consequently, this approach presents a solar cell array design based on individual cells.

Thus, a single laydown process and layout can be used in the fabrication of solar cell arrays. Current flow between solar cells will be assisted with conductors embedded in the substrate. These electrical connections define the specific characteristics of the solar cell array, such as its dimensions, stayout zones, and circuit terminations. This approach simplifies manufacturing, enables automation, and reduces costs and delivery times.

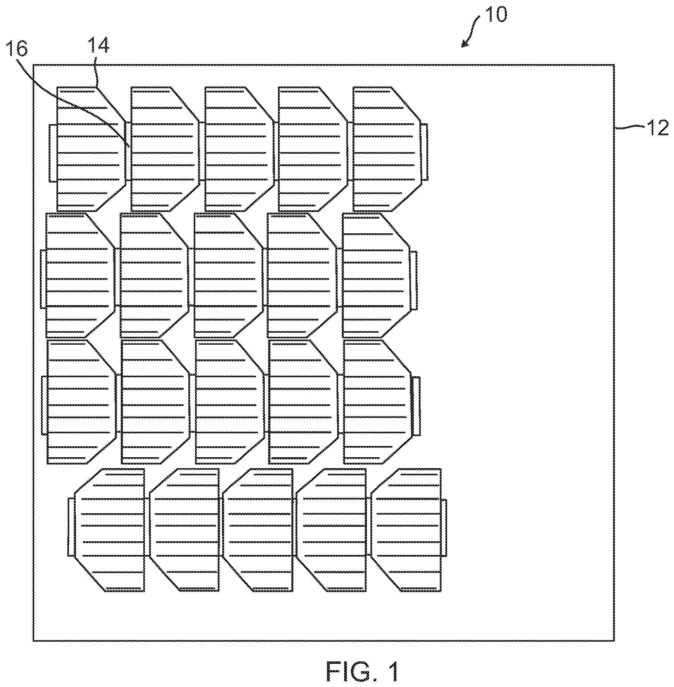

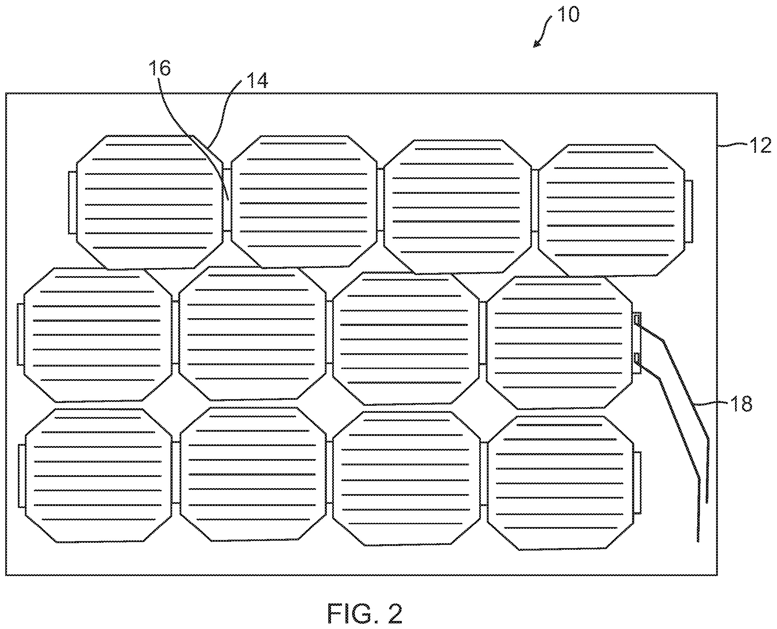

FIGS. 1 and 2 illustrate conventional structures for solar cell panels 10, which include a substrate 12, a plurality of solar cells 14 arranged in an array, and electrical connectors 16 between the solar cells 14. Half size solar cells 14 are shown in FIG. 1 and full size solar cells 14 are shown in FIG. 2. Space solar cells 14 are derived from a round Germanium (Ge) substrate starting material, which is later fabricated into semi-rectangular shapes to improve dense packing onto the solar cell panel 10. This wafer is often diced into one or two solar cells 14 herein described as half size or full size solar cells 14. The electrical connectors 16 providing electrical connections between solar cells 14 are made along the long parallel edge between solar cells 14. These series connections (cell-to-cell) are completed off-substrate, as strings of connected solar cells 14 are built having lengths of any number of solar cells 14. The completed strings of solar cells 14 are then applied and attached to the substrate 12.

In FIG. 2, wiring 18 is attached at the end of a string of solar cells 14 to electrically connect the string to other strings, or to terminate the resulting circuit and bring the current off of the array of solar cells 14. String-to-string and circuit termination connections are typically done on the substrate 12, and typically using wiring 18. However, some solar cell panels 10 use a printed circuit board (PCB)-type material with embedded conductors.

Adjacent strings of connected solar cells 14 can run parallel or anti-parallel. In addition, strings of connected solar cells 14 can be aligned or misaligned. There are many competing influences to the solar cell 14 layout resulting in regions where solar cells 14 are parallel or anti-parallel, aligned or misaligned.

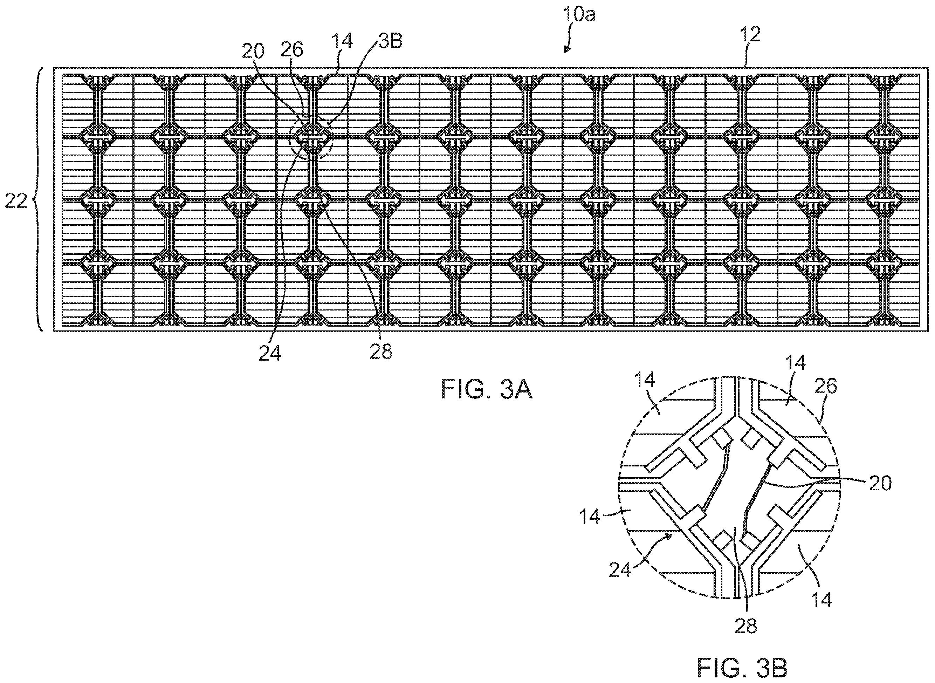

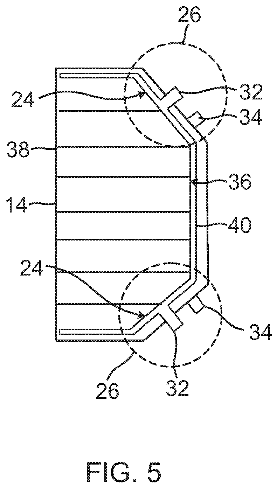

FIGS. 3A and 3B illustrate improved devices and structures for a solar cell panel 10a, according to one example, wherein FIG. 3B is an enlarged view of the details in the dashed circle in FIG. 3A. The various components of the solar cell panel 10a are shown and described in greater detail in FIGS. 5-13.

The solar cell panel 10a includes a substrate 12 for solar cells 14 having one or more corner conductors 20 thereon. In one example, the substrate 12 is a multi-layer substrate 12 comprised of one or more Kapton^{®} (polyimide) layers separating one or more patterned metal layers. The substrate 12 may be mounted on a large rigid panel 10a similar to conventional assembles. Alternatively, the substrate 12 can be mounted to a lighter, more sparse frame or panel 10a for mounting or deployment.

A plurality of solar cells 14 are attached to the substrate 12 in a two-dimensional (2-D) grid of an array 22. In this example, the array 22 is comprised of ninety-six (96) solar cells 14 arranged in four (4) rows by twenty-four (24) columns, but it is recognized that any number of solar cells 14 may be used in different implementations.

The solar cells 14 have cropped corners 24 that define corner regions 26, as indicated by the dashed circle. The solar cells 14 are attached to the substrate 12, such that corner regions 26 of adjacent ones of the solar cells 14 are aligned, thereby exposing an area 28 of the substrate 12. The area 28 of the substrate 12 that is exposed includes one or more of the corner conductors 20, and one or more electrical connections between the solar cells 14 and the corner conductors 20 are made in the corner regions 26 resulting from the cropped corners 24 of the solar cells 14.

In this example, the corner conductors 20 are conductive paths attached to, printed on, buried in, or deposited on the substrate 12, before and/or after the solar cells 14 are attached to the substrate 12, which facilitate connections between adjacent solar cells 14. The connections between the solar cells 14 and the corner conductors 20 are made after the solar cells 14 have been attached to the substrate 12.

In one example, four adjacent solar cells 14 are aligned on the substrate 12, such that four cropped corners 24, one from each solar cell 14, are brought together at the corner regions 26. The solar cells 14 are then individually attached to the substrate 12, wherein the solar cells 14 are placed on top of the corner conductors 20 to make the electrical connection between the solar cells 14 and the corner conductors 20.

The solar cells 14 may be applied to the substrate 12 as CIC (cell, interconnect and coverglass) units. Alternatively, bare solar cells 14 may be assembled on the substrate 12, and then interconnects applied to the solar cells 14, followed by the application of a single solar cell 14 coverglass, multiple solar cell 14 coverglass, multiple cell polymer coversheet, or spray encapsulation. This assembly protects the solar cells 14 from damage that would limit performance.

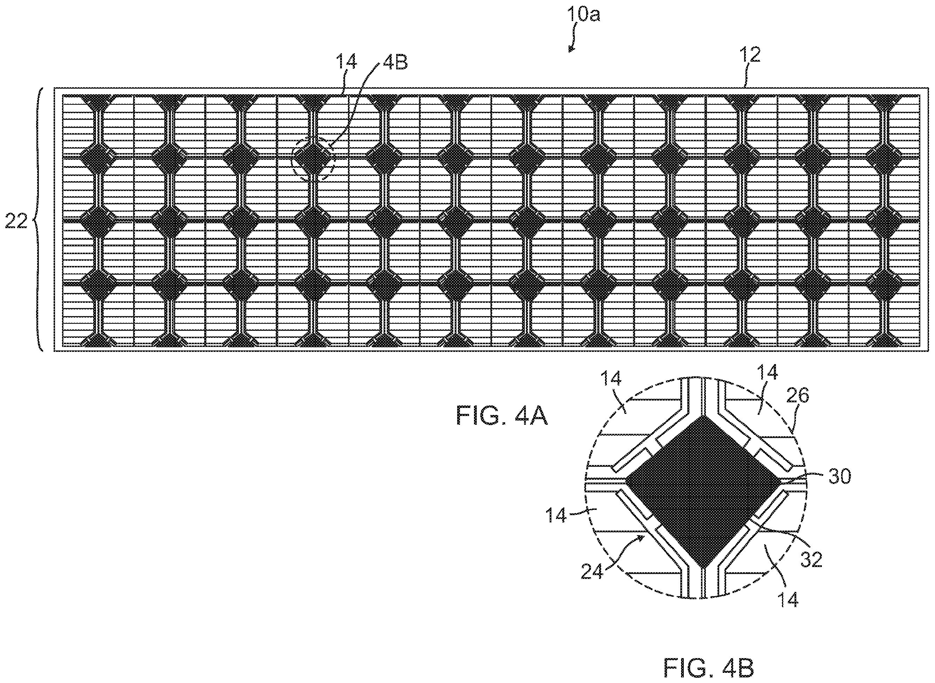

FIGS. 4A and 4B illustrate an alternative structure for the solar cell panel 10a, according to one example, wherein FIG. 4B is an enlarged view of the details in the dashed circle in FIG. 4A. In this example, only a few corner conductors 20 are printed on or integrated with the substrate 12. Instead, most of the corner conductors 20 are contained within a power routing module (PRM) 30 that is attached to the substrate 12.

FIG. 5 illustrates the front side of an exemplary solar cell 14 that may be used in the improved solar cell panel 10a of FIGS. 3A-3B and 4A-4B. The solar cell 14, which is a CIC unit, is a half-size solar cell 14. (Full-size solar cells 14 could also be used.)

The solar cell 14 is fabricated having at least one cropped corner 24 that defines a corner region 26, as indicated by the dashed circle, such that the corner region 26 resulting from the cropped corner 24 includes at least one contact 32, 34 for making an electrical connection to the solar cell 14. In the example of FIG. 5, the solar cell 14 has two cropped corners 24, each of which has both a front contact 32 on the front side of the solar cell 14 and a back contact 34 on a back side of the solar cell 14, where the contacts 32 and 34 extend into the corner region 26. (Full-size solar cells 14 would have four cropped corners 24, each of which would have a front contact 32 and a back contact 34.)

The cropped corners 24 increase utilization of the round wafer starting materials for the solar cells 14. In conventional panels 10, these cropped corners 24 would result in unused space on the panel 10 after the solar cells 14 are attached to the substrate 12. The new approach described in this disclosure, however, utilizes this unused space. Specifically, metal foil interconnects, comprising the corner conductors 20, front contacts 32 and back contacts 34, are moved to the corner regions 26. In contrast, existing CICs have interconnects attached to the solar cell 14 front side, and connect to the back side (where connections occur) during stringing.

The current generated by the solar cell 14 is collected on the front side of the solar cell 14 by a grid 36 of thin metal fingers 38 and wider metal bus bars 40 that are connected to both of the front contacts 32. There is a balance between the addition of metal in grid 36, which reduces the light entering the solar cell 14 and its output power, and the reduced resistance of having more metal. The bus bar 40 is a low resistance conductor that carries high currents and also provides redundancy should a front contact 32 become disconnected. Optimization generally desires a short bus bar 40 running directly between the front contacts 32. Having the front contact 32 in the cropped corner 24 results in moving the bus bar 40 away from the perimeter of the solar cell 14. This is achieved while simultaneously minimizing the bus bar 40 length and light obscuration. Additionally, the fingers 38 are now shorter. This reduces parasitic resistances in the grid 36, because the length of the fingers 38 is shorter and the total current carried is less. This produces a design preference where the front contacts 32 and connecting bus bar 40 is moved to provide shorter narrow fingers 38.

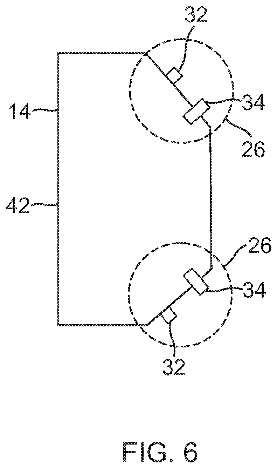

FIG. 6 illustrates the back side of the exemplary solar cell 14 of FIG. 5. The back side of the solar cell 14 has a metal back layer 42 that is connected to both of the back contacts 34.

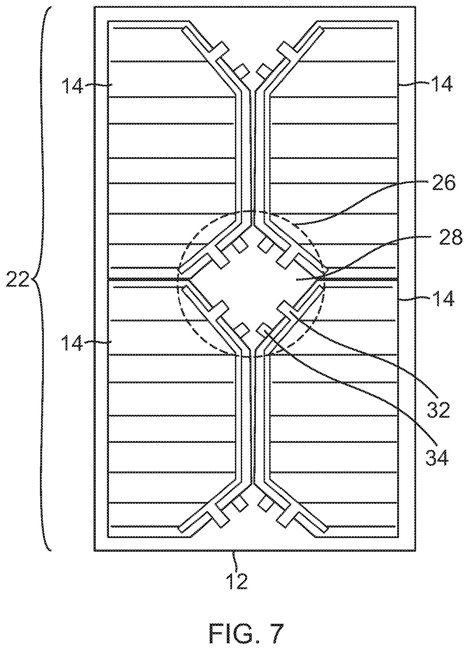

FIG. 7 illustrates solar cells 14 arranged into the 2D grid of the array 22, according to one example. The array 22 comprises a plurality of solar cells 14 attached to a substrate 12, such that corner regions 26 of adjacent ones of the solar cells 14 are aligned, thereby exposing an area 28 of the substrate 12. Electrical connections (not shown) between the solar cells 14 are made in the exposed area 28 of the substrate 12 using the front contacts 32 and back contacts 34 of the solar cells 14 and corner conductors 20 (not shown) formed on or in the exposed area 28 of the substrate 12.

During assembly, the solar cells 14 are individually attached to the substrate 12. This assembly can be done directly on a support surface, i.e., the substrate 12, which can be either rigid or flexible. Alternatively, the solar cells 14 could be assembled into the 2D grid of the array 22 on a temporary support surface and then transferred to a final support surface, i.e., the substrate 12.

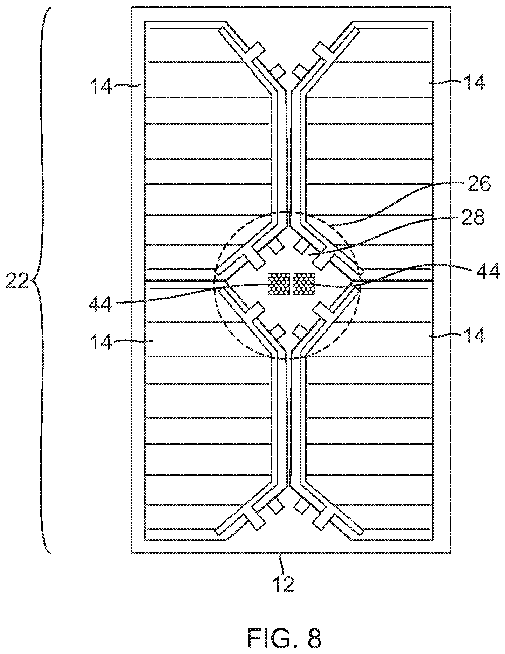

FIG. 8 illustrates an example of the array 22 where one or more bypass diodes 44 are added to the exposed area 28 of the substrate 12 in the corner regions 26, for use in one or more of the electrical connections. The bypass diodes 44 protect the solar cells 14 when the solar cells 14 become unable to generate current, which could be due to being partially shadowed, which drives the solar cells 14 into reverse bias. In one example, the bypass diodes 44 are attached to the substrate 12 in the corner regions 26 independent of the solar cells 14.

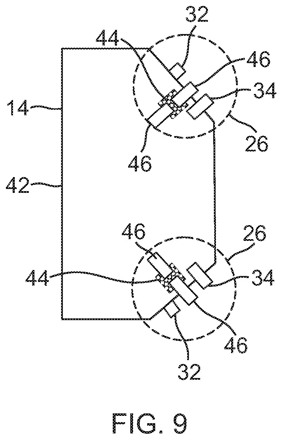

FIG. 9 illustrates an example where the bypass diode 44 is applied to the back side of the solar cell 14, with interconnects or contacts 46 for the bypass diode 44 connected to the back layer 42 and also extending into the corner region 26 between the front and back contacts 32, 34.

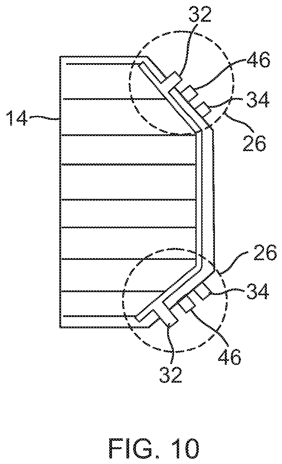

FIG. 10 illustrates a front side view of the example of FIG. 9, with the interconnect or contact 46 for the bypass diode 44 (not shown) extending into the corner region 26 between the front and back contacts 32, 34.

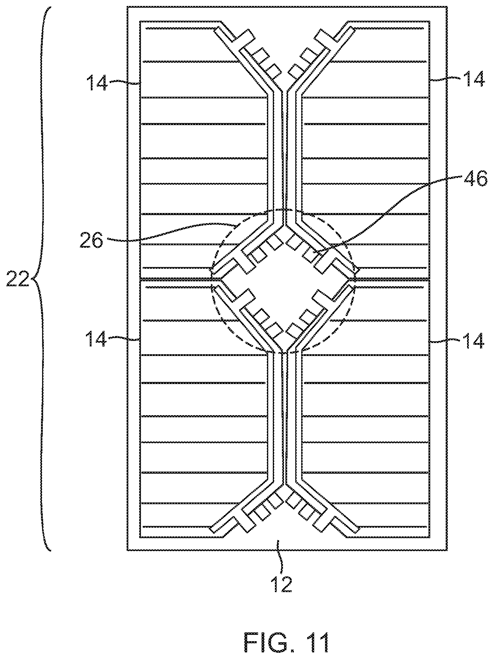

FIG. 11 illustrates the solar cells 14 of FIGS. 9 and 10 arranged into the 2D grid of the array 22 and applied to the substrate 12, where the bypass diodes 44 (not shown) are applied to the back side of the solar cells 14, with the contacts 46 for the bypass diodes 44 extending into the corner regions 26 of the solar cells 14.

One advantage of this approach is that the layouts illustrated in FIGS. 7, 8 and 11 are generalized layouts. Specifically, these layouts can be repeated across any panel 10a dimensions desired by a customer. This greatly simplifies assembly, rework, test, and inspection processes.

The placement of the solar cell 14 and bypass diode 44 is generic. The electrical connection of the solar cells 14 into series connections and string terminations is important customization for the end customer and is done independent of the layout. The front contacts 32 and back contacts 34 in the corner regions 26 of the solar cells 14 must be connected. This can be done in many combinations in order to route current through a desired path.

Connections are made between the solar cells 14 and the corner conductors 20. Front and back contacts 32, 34 of the solar cells 14 are present in each corner region 26 for attachment to the corner conductors 20. Interconnects for the front and back contacts 32, 34 of each of the solar cells 14 are welded, soldered, or otherwise bonded onto the corner conductors 20 to provide a conductive path 20, 32, 34 for routing current out of the solar cells 14.

Using the corner conductors 20, any customization can be made in the electrical connections. Adjacent solar cells 14 can be electrically connected to flow current in up/down or left/right directions as desired by the specific design. Current flow can also be routed around stay-out zones as needed. The length or width of the solar cell array 22 can be set as desired. Also, the width can vary over the length of the array 22.

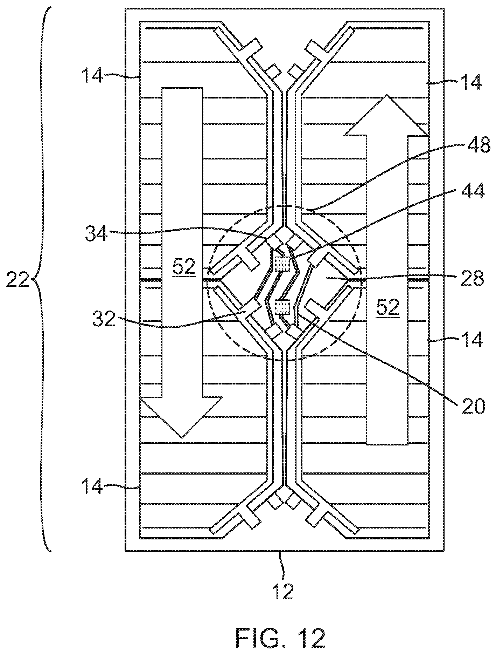

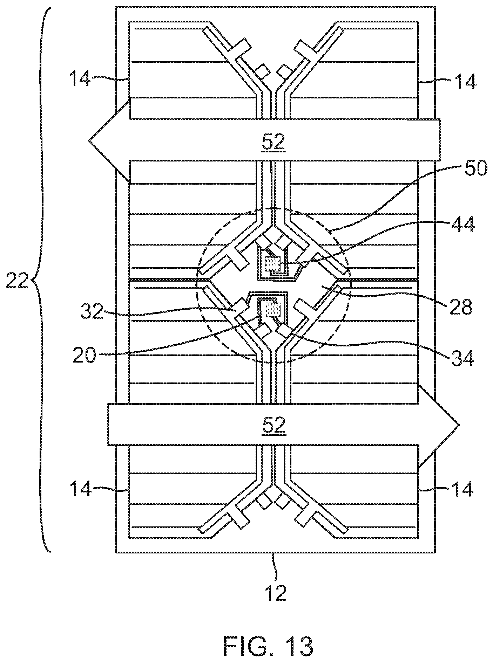

In one example, the electrical connections are series connections that determine a flow of current through the plurality of solar cells 14. This may be accomplished by the connection schemes shown in FIGS. 12 and 13, wherein FIG. 12 shows up/down series connections 48 between the solar cells 14 of the array 22, and FIG. 13 shows left/right series connections 50 between the solar cells 14 of the array 22. In both FIGS. 12 and 13, these series connections 48, 50 are electrical connections between the front contacts 32 and back contacts 34 of the solar cells 14, and the bypass diodes 44, are made using the corner conductors 20 formed on or in the exposed areas 28 of the substrate 12. These series connections 48, 50 determine the current (power) flow, as indicated by the arrows 52, through the solar cells 14.

The corner conductors 20 between solar cells 14 can be in many forms. They could be accomplished using wires that have electrical connections made on both ends, which could be from soldering, welding, conducting adhesive, or other process. In addition to wires, metal foil connectors, similar to the interconnects could be applied. Metal conductive paths or traces (not shown) can also be integrated with the substrate 12.

In summary, this new approach attaches the solar cells 14 individually to a substrate 12 such that the corner regions 26 of two, three or four adjacent solar cells 14 are aligned on the substrate 12. The solar cells 14 can be laid out so that the cropped corners 24 are aligned and the corner regions 26 are adjacent, thereby exposing an area 28 of the substrate 12. Electrical connections between solar cells 14 are made in these corner regions 26 between front contacts 32 and back contacts 34 on the solar cells 14, bypass diodes 44, and corner conductors 20 on or in the exposed area 28 of the substrate 12, wherein these conductive paths are used to create a string of solar cells 14 in a series connection 48, 50 comprising a circuit.

### SOLAR CELL ARRAY WITH BYPASSED SOLAR CELLS

Space-based solar cell arrays 22 cannot generally be serviced. Failures are therefore of major concern, and lead to extensive quality programs, as well as avoidance of some missions.

The solar cell arrays 22 produce power by stringing together many solar cells 14 to produce an output voltage. In one example, a string of 50 solar cells 14 in series produces an output voltage of 100V. A failure of one or more solar cells 14 in the string can greatly compromise the power delivered by all 50 solar cells 14.

This disclosure provides a mechanism to bypass a solar cell 14, so that it does not compromise the string. Also, the string length can be changed by add or removing solar cells 14. Together, these capabilities enable the solar cell array 22 to continue producing power in the event of solar cell 14 failures.

Solar cells 14 are generally series-connected in a string. A single triple junction solar cell 14 in the string produces approximately 2V. Photocurrent exits the backside (i.e., the p-side) of the solar cell 14, wherein the backside of a first solar cell 14 is series-connected to the front side (i.e., the n-side) of a second solar cell 14. The photocurrent again exits the backside of the second solar cell 14. The current is constant through the series-connected solar cells 14, but gains 2V from each additional solar cell 14.

A key design specification is the voltage needed for operation of the system. This is often 100V, but ranges greatly.

Damage to a solar cell 14, bypass diode 44, or their electrical connections, can greatly reduce the power delivered by the string. Because of the series-connected nature of the string, failure of one or more solar cells 14 can reduce the power output by 50% or more.

This disclosure describes bypassing a solar cell 14, and its bypass diode 44, from the string, which would result in the solar cell 14 being removed from the string, causing a voltage reduction for the string. In order to maintain the output voltage and peak power generation, the string should also change, by adding solar cells 14 to the string, after removing solar cells 14 from the string. Typically, the string's length would be maintained or increased, in order to provide the 100V output without degradation by the bypassed solar cell 14.

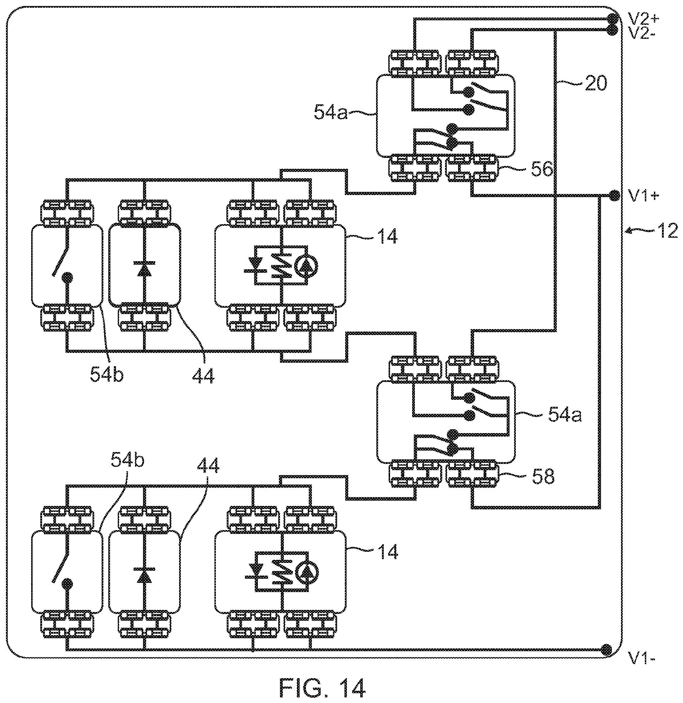

FIG. 14 shows a circuit diagram of a string comprised of two solar cells 14 attached to a substrate 12, wherein the substrate 12 includes one or more electrical connections to the solar cells 14, and each solar cell 14 has a bypass diode 44. Each solar cell 14 also has a set of one or more string length switches 54a to change the string length and a bypass switch 54b to bypass the solar cell 14, thereby altering the electrical connections to the solar cells 14.

The solar cell 14 includes a current source, shunt resistance, and diode, which is a common circuit representation. This simplifies consideration of how the solar cell array 22 may change. Shadowing or fracturing of the solar cell 14 would decrease the current source. Damage to the solar cell 14 can reduce the shunt resistance.

Also shown are the interconnects 56, each of which comprise two flange elements with parallel planes connected by a web element, thus appearing similar to the letter H tilted on its side. The interconnects 56 are metal foil pieces used to connect the devices (solar cell 14, bypass diode 44, switches 54) to the conductors 20.

The connections 58 between the interconnects 56, devices 14, 44, 54 and conductors 20 are shown as small squares. These connections 58 can be soldered or welded connections 58.

The conductors 20 could possibly be wires, but the complex network of electrical connections between solar cells 14 would be prohibitive, requiring extensive labor and taking up panel 10a area. However, the use of corner conductors 20 in the solar cell array 22 enables this approach. This solar cell 14 layout puts the needed conductors 20 all in close proximity (in the corner regions 26) and allows the devices 14, 44, 54 also to be in the corner region 26.

Then, the solar cells 14 can be assembled on the substrate 12, such as a flex circuit substrate 12, which are readily available with space-approved construction methods. The flex circuit substrate 12 has metal traces that can form the wiring patterns of electrical connections shown in the figure. These electrical connections would be virtually impossible in a conventional solar cell array, but become straightforward in the corner connection layout of this disclosure.

FIG. 14 shows a string with a length of two solar cells 14. This is not very useful in practice, but is useful to demonstrate the functionality of this disclosure. The polarity is such that, when illuminated, photocurrent will flow up in each solar cell 14 as shown by the up arrow current source. The resulting voltage will also be greater at the top (VX+ connections) rather than the bottom of the figure. The two string length switches 54a on the right-hand side can control the outputs. The outputs shown include a positive and negative polarity of two outputs V1 and V2. V1- is fixed as the starting point of the solar cell array 22. After the bottom solar cell 14, a set of string length switches 54a can control the output to terminate to V1+. If this is the case, then the top solar cell 14 would be connected to V2-. And, the output of the top solar cell 14 would then be switch-connected by a set of string length switches 54a to V2+. In this configuration, there would be two outputs with the power of one solar cell 14 in each output.

The string length switches 54a could also be set such that, after the bottom solar cell 14, the current continues to the top solar cell 14, albeit through two string length switches 54a. Then, the current continues through the top solar cell 14, where the voltage is boosted. The output is then directed to V1+. V1+ has the same current as before, but now twice the voltage. The circuit lines V2- and V2+ can be connected together to avoid any floating, unconnected conductors.

If a solar cell 14 or bypass diode 44 is not operating correctly, the bypass switches 54b on the left side can be closed to bypass a solar cell 14 and bypass diode 44 from the string. When closed, the switch 54b would form a low resistance path bypassing the solar cell 14, the results of which would be a solar cell 14 with nearly 0 volts across it and little to no current flowing.

This action would remove the solar cell 14 from the string resulting in a voltage reduction for the string. In order to maintain the output voltage and peak power generation, the string should also change, which requires another set of switches 54a to add a functioning solar cell 14 to the string. Typically, the string length would be maintained or increased so that the string would then provide the 100V output without degradation by the bypassed solar cell 14.

The typical building block for the space-based solar cell array 22 is a solar cell 14 and bypass diode 44. In this disclosure, the building block now becomes solar cell 14, bypass diode 44, string length switches 54a, and bypass switch 54b. This highly functional building block can be used to build a solar cell array 22 with incredible functionality, when combined with a corner connection layout.

The resulting configuration would allow any single solar cell 14, or groups of solar cells 14, to be bypassed. The current would then route through bypass switches 54b around the solar cell 14. The string length could then be expanded as needed to reach the required output voltage. FIG. 14 shows switch control and bypass control at the level of each individual solar cell 14. It is straightforward to modify the connections so that a group of solar cells 14 can be bypassed as s group. This is similar to switching the solar cells 14 as group.

The bypass diode 44 serves a similar role as the bypass switch 54b. The bypass switch 54b is controlled through an external system that senses operation, determines switch configurations, and transmits the information to the switches. These operations are internal and automatic to the bypass diode 44. If the bypass diode 44 has an applied forward bias > 0.7V, current will automatically flow through the bypass diode 44 with a low resistance. With an appropriate sensing and control system, the bypass switch 54b could eliminate the need for the bypass diode 44.

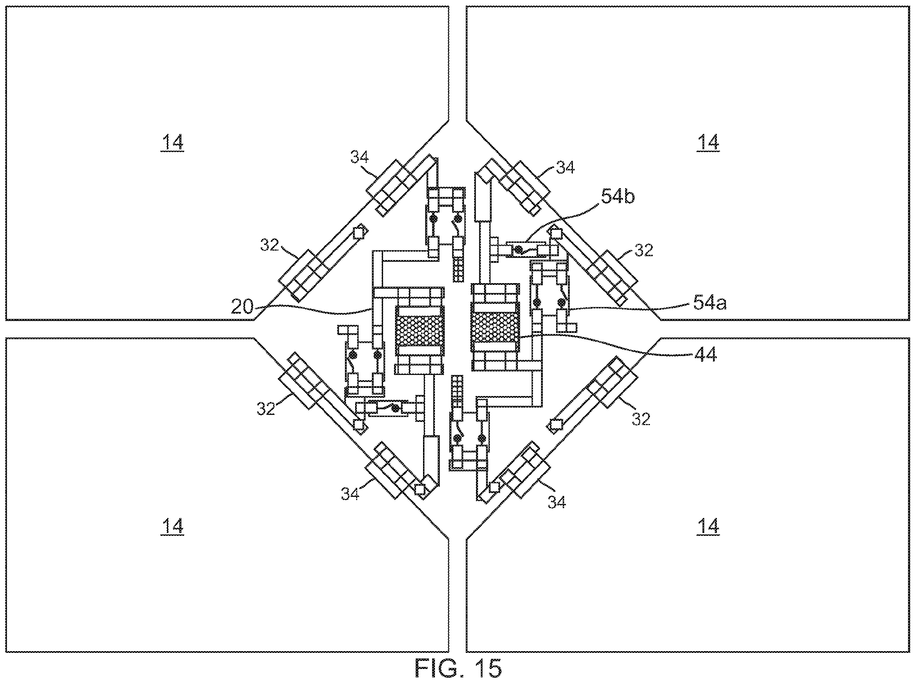

FIG. 15 shows how a solar cell 14 is bypassed by a single bypass switch 54b that connects the front and back contacts 32, 34 of the solar cell 14 in the corner connection layout. In addition, sets of string length switches 54a are used to adjust the string length.

A corner connection layout is used for the solar cell array 22, which in this example is comprised of four solar cells 14, each having at least one cropped corner 24. The solar cells 14 are attached to the substrate 12, i.e., a flex circuit substrate 12, such that corner regions 26 of adjacent ones of the solar cells 14 resulting from the cropped corners 24 are aligned, thereby exposing an area 28 of the substrate 12. Front and back contacts 32, 34 for the solar cells 14 extend into the exposed area 28 of the substrate 12. The exposed area 28 of the substrate 12 also includes corner conductors 20 for making one or more electrical connections between the front and back contacts 32, 34 of the solar cells 14, as well as bypass diodes 44, string length switches 54a, and bypass switches 54b.

The exposed area 28 of the substrate 12 also includes one or more bypass switches 54b for bypassing the electrical connections to one or more of the solar cells 14, wherein the switches 54b, when closed, connect front and back contacts 32, 34 of the one or more of the solar cells 14 to bypass the electrical connections to the one or more of the solar cells 14. The corner connection layout simplifies the use of the bypass switches 54b, because the front and back contacts 32, 34 are physically adjacent to each other. In addition, the front and back contacts 32, 34 are accessible to the traces on the flex circuit substrate 12.

The corner connection layout also provides another important capability for the bypassing of solar cells 14. Specifically, the flex circuit substrate 12 can include traces underneath the solar cells 14 that are electrically isolated from the solar cell 14.

In addition, the exposed area 28 of the substrate 12 also includes one or more sets of switches 54a for altering a string of the solar cells 14 by adding and/or removing one or more of the solar cells 14 to or from the electrical connections of the string. The string is altered to change a voltage produced by the string.

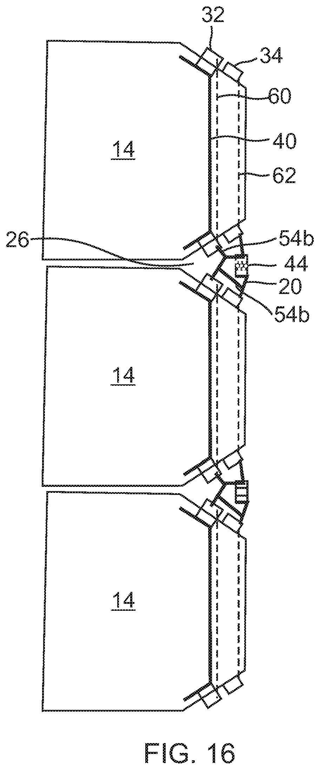

FIG. 16 shows a set of three solar cells 14 in a vertical column. The bus bar 40 is a low resistance metal conductor on the surface of the solar cell 14 that carries the current from individual narrow metal fingers 38 of the grid 36 (not shown) to the front contacts 32 of the solar cell 14. Each end of the bus bar 40 is connected to a front contact 32 that can connect to the traces on the flex sheet substrate 12. The back contact 34 is connected to the backside of the solar cell 14.

The dashed lines are traces 60, 62 in or on the flex sheet substrate 12 underneath the solar cells 14 that are electrically isolated from the solar cells 14. These traces 60, 62 provide a parallel current path for the front and back contacts 32, 34, respectively, of the solar cell 14 between each corner. These traces 60, 62 also provide a current path to bypass a solar cell 14 and allow for current flow underneath the solar cell 14, when a solar cell 14 is bypassed. This is similar to the discussion of stayout zones found in some of the applications cross-referenced above.

The corner regions 26 may also include a bypass diode 44, as well as corner conductors 20 which support series connection of these solar cells 14. The current will flow from top to bottom through these three solar cells 14.

Bypass switches 54b are shown in the corner regions 26 as well. Only a single by-pass switch 54b is necessary in each corner region 26, but a second bypass switch 54b in a corner region 26 provides further protection from failure.

Referring again to FIG. 15, the switches 54 are shown as single-pole single-throw (SPST) switches 54. Such switches 54 could be semiconductor-based, for example, Silicon (Si) MOSFETs (metal-oxide-semiconductor field-effect transistors), or Gallium Nitride (GaN) or Silicon Carbide (SiC) FETs (field-effect transistors), and are available from multiple vendors for space applications.

To simplify assembly, however, the functions of the switches 54 and bypass diode 44 could be combined into a single integrated device. Semiconductor or MEMS (micro-electrical-mechanical system) switches 54 could be well integrated with the bypass diode 44 on a common semiconductor wafer or through various integration approaches.

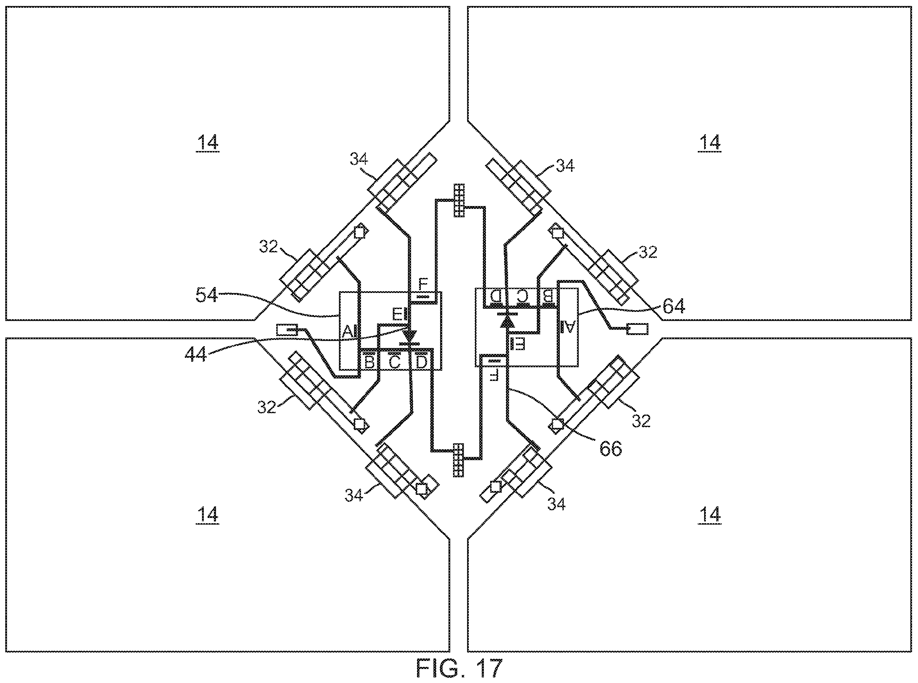

A single integrated device 64 combining the switch 54 functions with a bypass diode 44 is shown in FIG. 17. The heavy dark lines represent conducting paths 66 in the corner region 26 and through the integrated device 64. The short parallel lines labeled A through F within the integrated device 64 represent switches 54, which can change the resistance in that region from very low to very high. The diode symbol between switches E and C/D 54 represents a bypass diode 44. Operation of these switches 54 control the operation of the series versus circuit termination and the solar cell 14 bypassing performed by the integrated device 64.

The device 64 in FIG. 17 has one more switch 54 than the layouts in FIGS. 14 and 15. This extra switch 54 enables termination of either solar cell 14 connected to the device 64. Another way to understand this is that each solar cell 14 in the configuration can terminate at either corner.

Not shown is the control of the integrated device 64 and its switches 54. This could be achieved with various communication strategies. A common method would be to serially transmit information including an address to identify the integrated device 64 and the switches 54 (A-F), and to transmit the open/close state of each switch 54. This serial communication is commonly implemented with a clock signal and an information signal with a power and ground line. These communication lines can be integrated into the flex circuit substrate 12. Since they do not carry much power or current, the size of the conductors can be much smaller than the other traces and can be integrated into the flex circuit substrate 12 without difficulty. There are many other ways to communicate information, such as through wireless communication, which could be electromagnetic or optical.

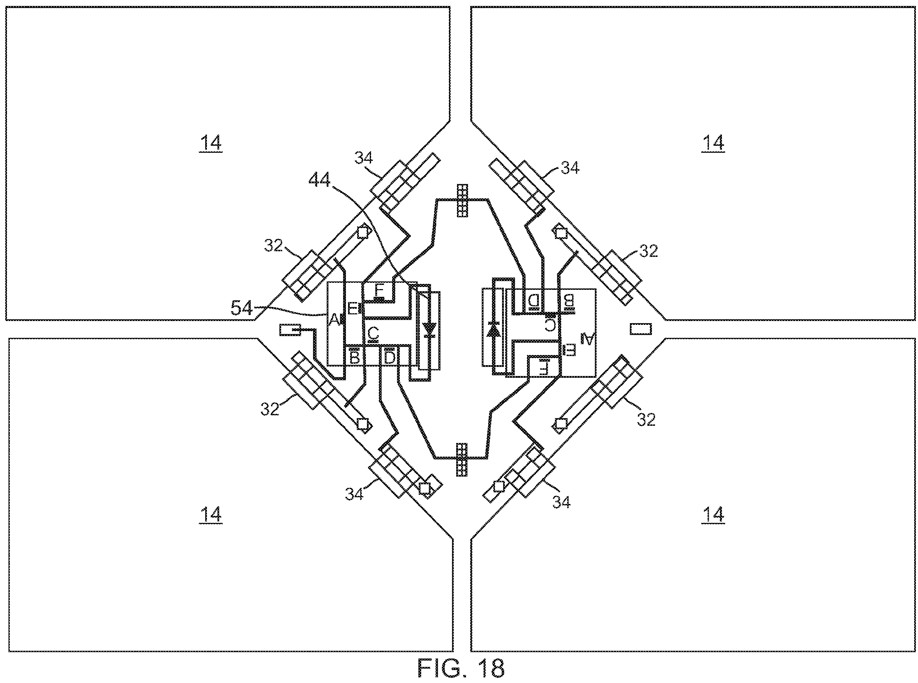

It may be desirable to make the switches 54 out of one semiconductor material and the bypass diode 44 out of another semiconductor material. For example, Gallium Nitride (GaN) may be preferred for the combined switches 54, while Si is preferred for the bypass diode 44. These functions can be separated into separate devices as shown in FIG. 18, wherein the bypass diode 44 is shown adjacent and connected to the combined switches 54.

### FABRICATION

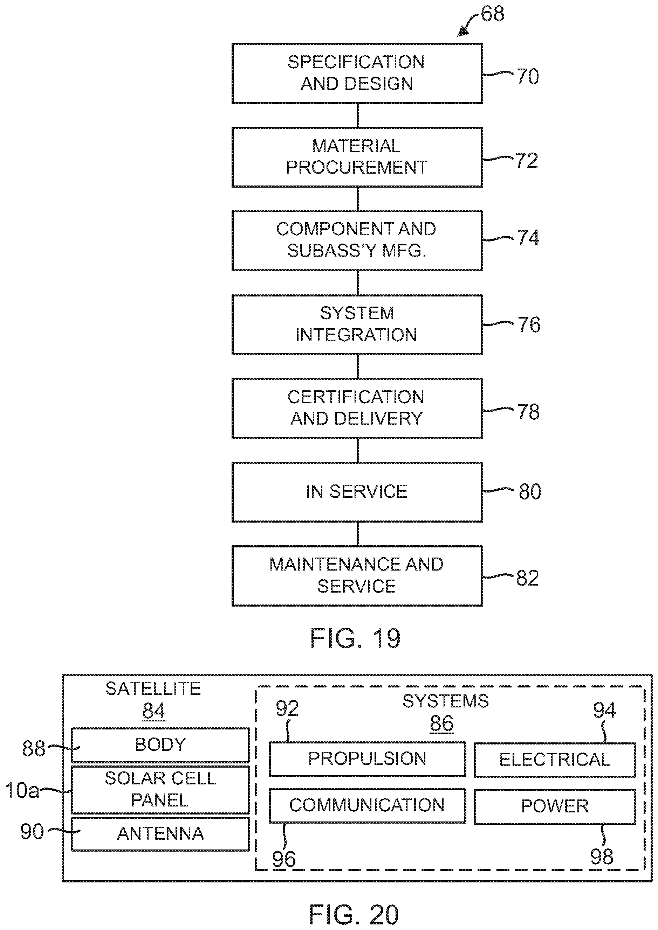

Examples of the disclosure may be described in the context of a method 68 of fabricating a solar cell 14, solar cell panel 10a and/or satellite, comprising steps 70-82, as shown in FIG. 19, wherein the resulting satellite 84 having a solar cell panel 10a comprised of solar cells 14 are shown in FIG. 20.

As illustrated in FIG. 19, during pre-production, exemplary method 68 may include specification and design 70 of the solar cell 14, solar cell panel 10a and/or satellite 84, and material procurement 72 for same. During production, component and subassembly manufacturing 74 and system integration 76 of the solar cell 14, solar cell panel 10a and/or satellite 84 takes place, which include fabricating the solar cell 14, solar cell panel 10a and/or satellite 84. Thereafter, the solar cell 14, solar cell panel 10a and/or satellite 84 may go through certification and delivery 78 in order to be placed in service 80. The solar cell 14, solar cell panel 10a and/or satellite 84 may also be scheduled for maintenance and service 82 (which includes modification, reconfiguration, refurbishment, and so on), before being launched.

Each of the processes of method 68 may be performed or carried out by a system integrator, a third party, and/or an operator (e.g., a customer). For the purposes of this description, a system integrator may include without limitation any number of solar cell, solar cell panel, satellite or spacecraft manufacturers and major-system subcontractors; a third party may include without limitation any number of venders, subcontractors, and suppliers; and an operator may be a satellite company, military entity, service organization, and so on.

As shown in FIG. 20, a satellite 84 fabricated by exemplary method 68 may include systems 86, a body 88, solar cell panels 10a comprised of solar cells 14, and one or more antennae 90. Examples of the systems 86 included with the satellite 84 include, but are not limited to, one or more of a propulsion system 92, an electrical system 94, a communications system 96, and a power system 98. Any number of other systems 86 also may be included.

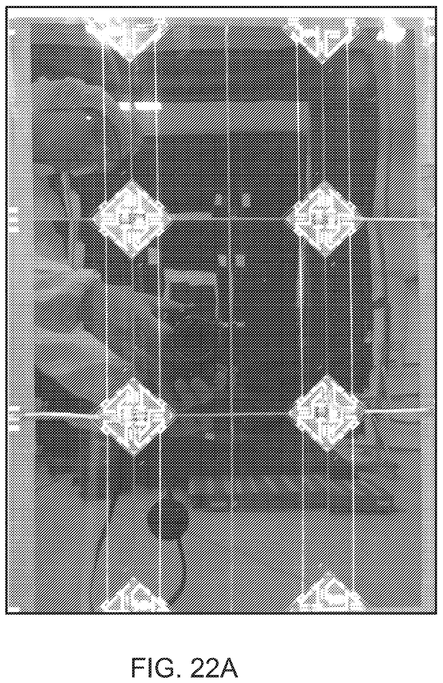

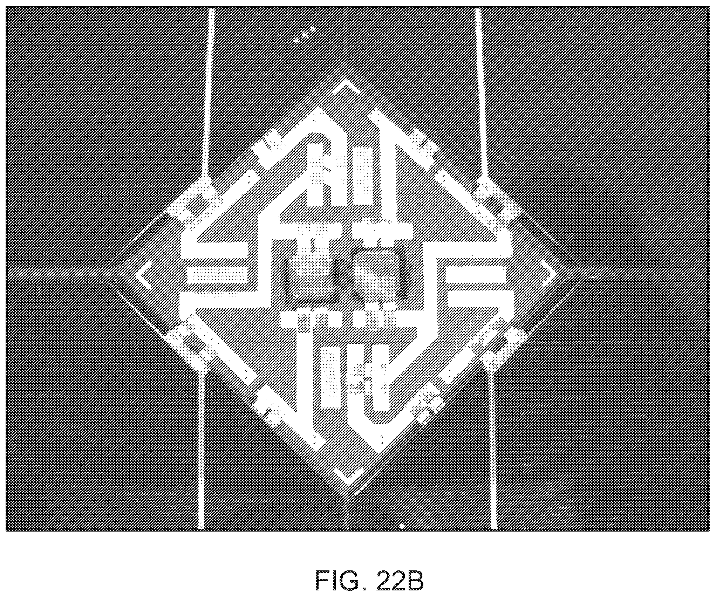

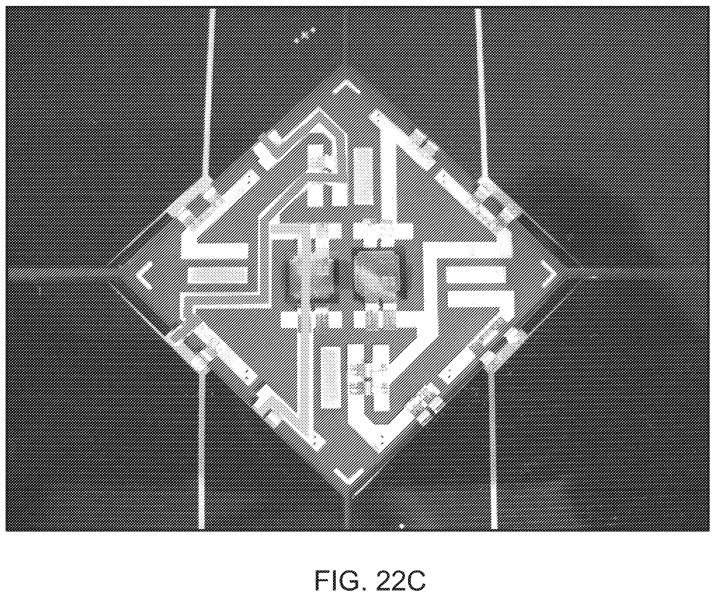

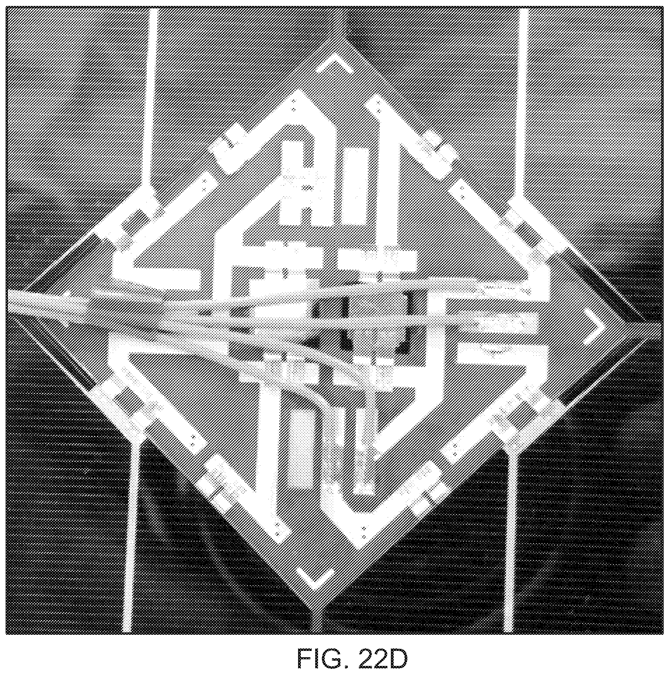

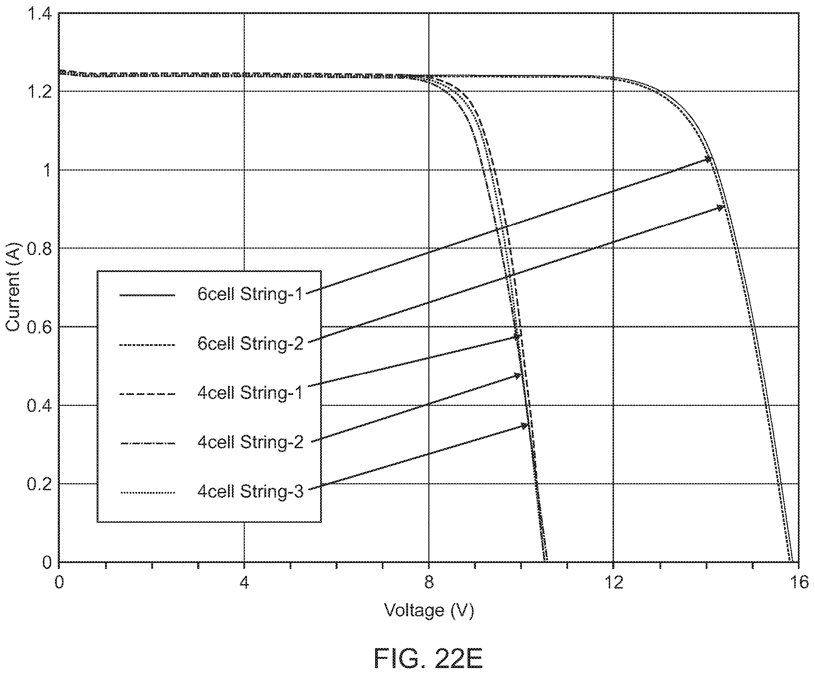

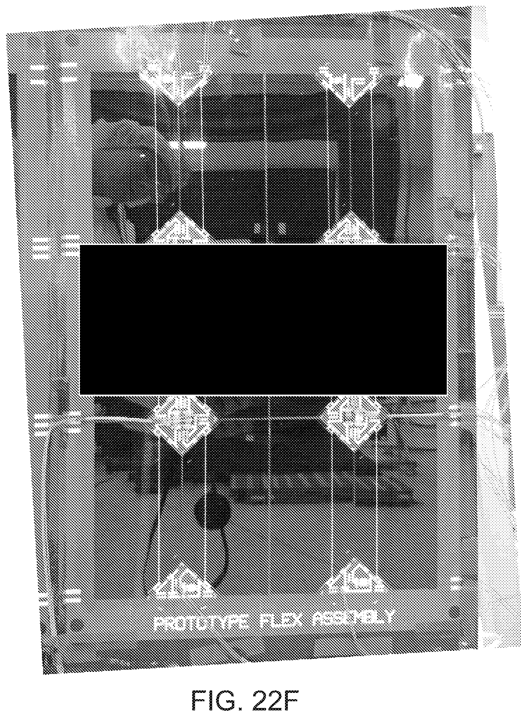

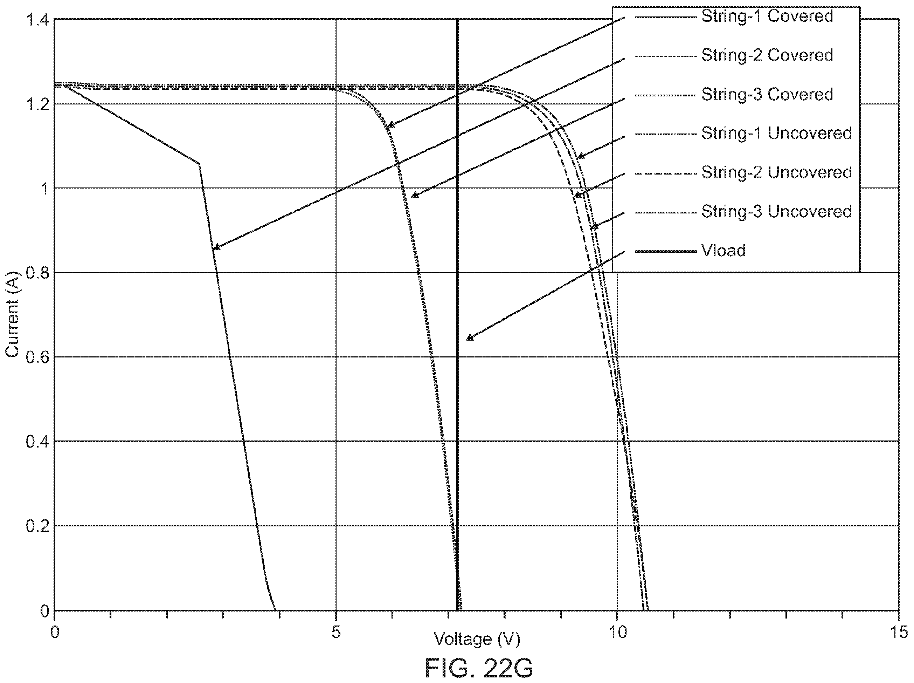

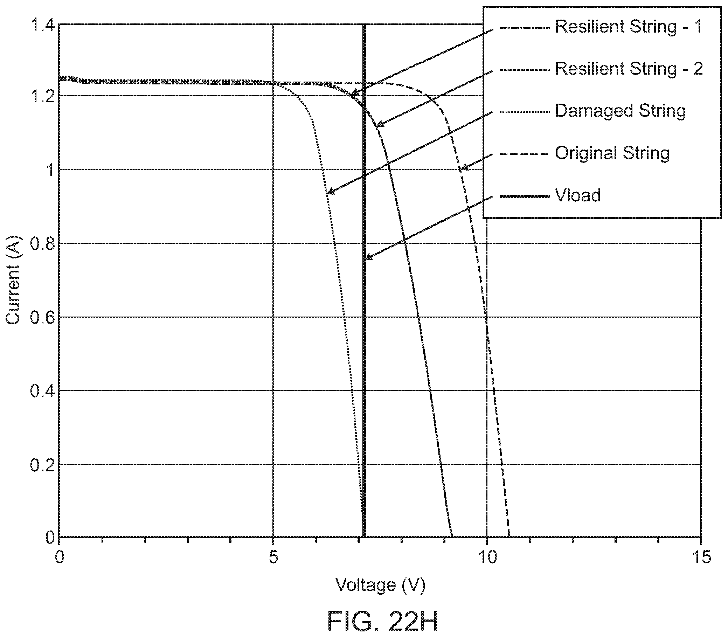

FIG. 22 is an illustration of the solar cell panel 10a in the form of a functional block diagram, according to one example. The solar cell panel 10a is comprised of the solar cell array 22, which is comprised of one or more of the solar cells 14 individually attached to the substrate 12. Each of the solar cells 14 absorbs light 100 from a light source 102 and generates an electrical output 104 in response thereto.

At least one of the solar cells 14 has at least one cropped corner 24 that defines a corner region 26, such that an area 28 of the substrate 12 remains exposed when the solar cell 14 is attached to the substrate 12. When a plurality of solar cells 14 are attached to the substrate 12, the corner regions 26 of adjacent ones of the solar cells 14 are aligned, thereby exposing the area 28 of the substrate 12.

The area 28 of the substrate 12 that remains exposed includes one or more corner conductors 20 attached to, printed on, or integrated with the substrate 12, and one or more electrical connections between the solar cells 14 and the corner conductors 20 are made in a corner region 26 resulting from the cropped corner 24 of the at least one of the solar cells 14.

The corner region 26 resulting from the cropped corner 24 includes at least one contact, for example, a front contact 32 on a front side of the solar cell 14 and/or a back contact 34 on a back side of the solar cell 14, for making the electrical connections between the corner conductors 20 and the solar cell 14. The electrical connections may comprise up/down or left/right series connections that determine a flow of power through the solar cells 14, and may include one or more bypass diodes 44.

The area 28 of the substrate 12 that remains exposed includes at least one switch 54, located in the corner region 26 defined by the cropped corners 24 adjacent to the solar cells 14, for changing a current flow path between the solar cells 14 and the electrical connections. The substrate 12 includes one or more traces connected to the switches 54 for making the electrical connections between the solar cells 14.

The switches 54a reconfigure string lengths for the electrical connections between the solar cells 14 and the switches 54b bypass solar cells 14 in response to a control signal. The switches 54a also reconfigure connections between strings allowing reconfigurability of series connections and outputs between the strings. The switches 54 may be single-pole single-throw (SPST) switches, or dual-pole single-throw (DPST) switches, or integrated devices that may be packaged to include functions other than switching functions, such as the functions of the bypass diode 44.

### EXPERIMENTAL RESULTS

A solar cell array based on the corner conductor design and using a flex circuit substrate was built to demonstrate the reconfiguration of the string length of the array.

FIG. 22A is an image of a demonstration solar cell array comprised of 12 solar cells arranged in three rows with each row having four solar cells. Electrical connections are made in the corner regions to provide either series connections or string terminations. The current flow or conduction paths were selected by welding a metal foil jumper in place. Wire pairs were added at several locations instead of metal jumpers, wherein these wires extended beyond the perimeter of the solar cell array.

FIG. 22B is an image showing a close-up view of one of the corner regions showing the electrical connections between the front contacts, back contacts, bypass diodes, and solar cells.

FIG. 22C is a version of FIG. 22B with the electrical connections between the upper left and the lower left solar cells indicated by the dark lines drawn over the conduction paths. One conduction path connects the back contact of the upper left solar cell to the front contact of the lower left solar cell, so that the current flows downward. Another conduction path connects the back contact of the lower left solar cell through the bypass diode.

The electrical connections between the upper right and the lower right solar cells are rotated 180 degrees as compared to the electrical connections between the upper left and the lower left solar cells, so that the current flows from the lower right solar cell to the upper right solar cell.

Jumpers are placed for series connections. By changing the jumper locations, the current flow can be terminated into buried traces.

FIG. 22D is an image of another corner region where wires have been added in place of jumpers. The wires could be shorted together to function like a jumper, or the wires could be isolated to function like the lack of a jumper.

In this demonstration, through the use of jumpers or wires, the configuration of the solar cell array with 12 solar cells can be changed from 2 strings with 6 solar cells to 3 strings with 4 solar cells.

FIG. 22E is a graph of light-current-voltage (LIV) measurements of the solar cell array under AM0 (air mass coefficient for zero atmosphere) illumination, wherein the measurements were made of the configurations of 2 strings with 6 solar cells and 3 strings with 4 solar cells. The change in voltage confirms the change in string length.

FIG. 22F is an image of the demonstration solar cell array of FIG. 22A, wherein the center 4 solar cells are covered to prevent their operation.

FIG. 22G is a graph of LIV measurements of the solar cell array under AM0 illumination, wherein the measurements were made of the configuration shown in FIG. 22F with the center 4 solar cells covered to prevent their operation. The covering of the solar cells is an experimental way to mimic damage to solar cells where the solar cell has reduced current or voltage output.

In this example, the solar cell array is configured to have 3 strings with 4 solar cells each. The data is shown for strings 1, 2 and 3 both covered and uncovered. When uncovered, the 3 strings have similar output with a voltage near 11V. When covered, 2 strings lose a solar cell and 1 string loses 2 solar cells. This loss of solar cells is reflected in the loss of voltage. The vertical line for Vload represents a load voltage where current would be collected by the power system. At this selection of load voltage, the load current would fall to near 0.

FIG. 22H is a graph of LIV measurements of the solar cell array under AM0 illumination, wherein the measurements were made of the configuration shown in FIG. 22F with the center 4 solar cells covered to prevent their operation.

In this example, the solar cell array is configured to have 2 strings with 6 solar cells each, wherein the 6 solar cells increase the power output of the string. With the center 4 solar cells covered to prevent their operation, there are 4 solar cells that are operating and 2 cells that are not operating in each string. Current must flow though the bypass diodes of the solar cells that are not operating, and thus the voltage output of the strings is that of 4 operating solar cells minus 2 bypass diodes.

The data in FIG. 22H shows the data for the original string before the center 4 solar cells are covered. Then, when the center 4 solar cells are covered, the voltage falls to the level indicated by the damaged string.

Reconfiguring to a string length of 6 solar cells increases the voltage and power output for resilient strings 1 and 2. Like FIG. 22G, the vertical line for Vload represents a load voltage. For resilient strings 1 and 2, the load current is now nearly that of the original string.

The power from the center 4 solar cells that are covered is still lost, of course. However, in a conventional solar cell array, damage to 4 out of 12 solar cells would largely eliminate the current at load delivered to the power system. In this example, by reconfiguring the solar cell array, power from each solar cell is able to be delivered to the power system with nearly optimal collection. Specifically, the original string delivers 2.2 Watts per solar cell at the load voltage, but when the center 4 solar cells are covered, the damaged string falls to 0.1 Watts per solar cell. After reconfiguration, the resilient strings 1 and 2 are able to deliver 2.1 Watts per functioning solar cell.

The addition of another switch to connect the front and back contacts of the solar cells in the array would improve power output. By doing this, the current would bypass the non-functioning solar cells in the array through the switch without power loss. however, this demonstration solar cell array does not provide this functionality, and thus there is power loss into the bypass diodes.

### CONCLUSION

The description of the examples set forth above has been presented for purposes of illustration and description, and is not intended to be exhaustive or limited to the examples described. Many alternatives, modifications and variations may be used in place of the specific elements described above. The invention is defined by the appended claims.

## Claims

1. A solar cell array, comprising:
a plurality of solar cells (14) attached to a substrate (12), wherein:
the substrate (12) includes one or more electrical connections to the solar cells (14); and
the substrate (12) includes one or more switches (54b) for bypassing one or more of the electrical connections to one or more of the solar cells (14),
wherein the solar cells (14), one or more bypass diodes (44), and the switches (54b) are electrically in parallel,
wherein an area (28) of the substrate (12) remains exposed when at least one of the solar cells (14) having one or more cropped corners (24) is attached to the substrate,
wherein the area of the substrate that remains exposed includes at least one of the switches (54b),
wherein the solar cells (14) are attached to the substrate (12) such that corner regions (26) defined by the cropped corners (24) of adjacent ones of the solar cells (14) are aligned, thereby exposing the area (28) of the substrate (12), and
wherein the at least one of the switches (54b) is located in the corner region (26) defined by the cropped corners (24) of adjacent ones of the solar cells (14).

2. The solar cell array of claim 1, wherein the switches (54b) bypass current around one or more of the solar cells.

3. The solar cell array of claim 1 or 2, wherein the switches (54b) are controlled by one or more control signals.

4. The solar cell array of any one of claims 1-3, wherein the switches (54b), when closed, connect front and back contacts (32, 34) of the one or more of the solar cells (14), so that current bypasses the one or more of the solar cells.

5. The solar cell array of any one of claims 1-4, further comprising one or more switches (54a) for adding or removing one or more of the solar cells to or from a string of the solar cells.

6. The solar cell array of claim 5, wherein a length of the string is altered to change a voltage produced by the string.

7. The solar cell array of any one of claims 1-6, wherein the electrical connections include one or more conductors (20) on or in the substrate (12).

8. The solar cell array of any one of claims 1-7, wherein the substrate (12) includes one or more traces connected to the bypass switches (54b) for making the electrical connections between the solar cells (14).

9. A method of operating a solar cell array, the solar array being according to claim 1, the method comprising:
controlling one or more switches (54b) in one or more electrical connections to one or more solar cells (14), for bypassing one or more of the electrical connections to one or more of the solar cells (14).

10. A method for fabricating a solar cell array, the solar cell array being according to claim 1, the method comprising:
attaching one or more solar cells (14) to the substrate (12).

11. The method of claim 10, wherein the switches (54b) bypass current around one or more of the solar cells.

12. The method of claim 10 or 11, wherein the switches (54b) are controlled by one or more control signals.

13. The method of any one of claims 10-12, wherein the switches (54b), when closed, connect front and back contacts (32, 34) of the one or more of the solar cells (14), so that current bypasses the one or more of the solar cells.

14. The method of any one of claims 10-13, wherein the electrical connections include one or more conductors (20) on or in the substrate (12).

15. The method of any one of claims 10-14, wherein the substrate (12) includes one or more traces connected to the bypass switches (54b) for making the electrical connections between the solar cells (14).

## Patentansprüche

1. Solarzellenanordnung, umfassend:
mehrere Solarzellen (14), die an einem Substrat (12) befestigt sind, wobei:
das Substrat (12) eine oder mehrere elektrische Verbindungen zu den Solarzellen (14) umfasst; und
das Substrat (12) einen oder mehrere Schalter (54b) zum Überbrücken einer oder mehrerer der elektrischen Verbindungen zu einer oder mehreren der Solarzellen (14) umfasst,
wobei die Solarzellen (14), ein oder mehrere Bypass-Dioden (44) und die Schalter (54b) elektrisch parallel geschaltet sind,
wobei ein Bereich (28) des Substrats (12) freiliegt, wenn mindestens eine der Solarzellen (14) mit einem oder mehreren abgeschrägten Ecken (24) an dem Substrat befestigt ist,
wobei der Bereich des Substrats, der freiliegt, mindestens einen der Schalter (54b) umfasst,
wobei die Solarzellen (14) so an dem Substrat (12) befestigt sind, dass Eckbereiche (26), die durch die abgeschrägten Ecken (24) benachbarter Solarzellen (14) definiert sind, ausgerichtet sind, wodurch der Bereich (28) des Substrats (12) freiliegt, und
wobei der mindestens eine der Schalter (54b) sich in dem Eckbereich (26) befindet, der durch die abgeschrägten Ecken (24) benachbarter Solarzellen (14) definiert ist.

2. Solarzellenanordnung nach Anspruch 1, wobei die Schalter (54b) Strom um eine oder mehrere der Solarzellen herumleiten.

3. Solarzellenanordnung nach Anspruch 1 oder 2, wobei die Schalter (54b) durch ein oder mehrere Steuersignale gesteuert werden.

4. Solarzellenanordnung nach einem der Ansprüche 1 bis 3, wobei die Schalter (54b), wenn sie geschlossen sind, Vorder- und Rückseitenkontakte (32, 34) der einen oder mehreren der Solarzellen (14) verbinden, sodass Strom die eine oder mehreren der Solarzellen umgeht.

5. Solarzellenanordnung nach einem der Ansprüche 1 bis 4, weiterhin umfassend einen oder mehrere Schalter (54a) zum Hinzufügen oder Entfernen einer oder mehrerer der Solarzellen zu oder aus einem Strang von Solarzellen.

6. Solarzellenanordnung nach Anspruch 5, wobei eine Länge des Strangs geändert wird, um eine durch den Strang erzeugte Spannung zu verändern.

7. Solarzellenanordnung nach einem der Ansprüche 1 bis 6, wobei die elektrischen Verbindungen einen oder mehrere Leiter (20) auf oder im Substrat (12) umfassen.

8. Solarzellenanordnung nach einem der Ansprüche 1 bis 7, wobei das Substrat (12) eine oder mehrere Leiterbahnen umfasst, die mit den Bypass-Schaltern (54b) verbunden sind, um die elektrischen Verbindungen zwischen den Solarzellen (14) herzustellen.

9. Verfahren zum Betrieb einer Solarzellenanordnung, wobei die Solarzellenanordnung gemäß Anspruch 1 ist, umfassend:
Steuern eines oder mehrerer Schalter (54b) in einer oder mehreren elektrischen Verbindungen zu einer oder mehreren Solarzellen (14), um eine oder mehrere der elektrischen Verbindungen zu einer oder mehreren der Solarzellen (14) zu überbrücken.

10. Verfahren zur Herstellung einer Solarzellenanordnung, wobei die Solarzellenanordnung gemäß Anspruch 1 ist, umfassend:
Befestigen einer oder mehrerer Solarzellen (14) an dem Substrat (12).

11. Verfahren nach Anspruch 10, wobei die Schalter (54b) Strom um eine oder mehrere der Solarzellen herumleiten.

12. Verfahren nach Anspruch 10 oder 11, wobei die Schalter (54b) durch ein oder mehrere Steuersignale gesteuert werden.

13. Verfahren nach einem der Ansprüche 10 bis 12, wobei die Schalter (54b), wenn sie geschlossen sind, Vorder- und Rückseitenkontakte (32, 34) der einen oder mehrerer der Solarzellen (14) verbinden, sodass Strom die eine oder mehrere der Solarzellen umgeht.

14. Verfahren nach einem der Ansprüche 10 bis 13, wobei die elektrischen Verbindungen einen oder mehrere Leiter (20) auf oder im Substrat (12) umfassen.

15. Verfahren nach einem der Ansprüche 10 bis 14, wobei das Substrat (12) eine oder mehrere Leiterbahnen umfasst, die mit den Bypass-Schaltern (54b) verbunden sind, um die elektrischen Verbindungen zwischen den Solarzellen (14) herzustellen.

## Revendications

1. Réseau de cellules solaires, comprenant :
une pluralité de cellules solaires (14) fixées à un substrat (12), dans lequel :
le substrat (12) comporte une ou plusieurs connexions électriques aux cellules solaires (14) ; et
le substrat (12) comporte un ou plusieurs commutateurs (54b) pour contourner une ou plusieurs des connexions électriques à une ou plusieurs des cellules solaires (14),
dans lequel les cellules solaires (14), une ou plusieurs diodes de dérivation (44) et les commutateurs (54b) sont électriquement en parallèle,
dans lequel une zone (28) du substrat (12) reste exposée lorsqu'au moins une des cellules solaires (14) ayant un ou plusieurs angles coupés (24) est fixée au substrat ;
dans lequel la zone du substrat qui reste exposée comporte au moins un des commutateurs (54b),
dans lequel les cellules solaires (14) sont fixées au substrat (12), de telle sorte que des régions d'angle (26) définies par les angles coupés (24) des cellules adjacentes parmi les cellules solaires (14) sont alignées, permettant ainsi d'exposer la zone (28) du substrat (12), et
dans lequel l'au moins un des commutateurs (54b) est situé dans la région d'angle (26) définie par les angles coupés (24) des cellules adjacentes parmi les cellules solaires (14).

2. Réseau de cellules solaires selon la revendication 1, dans lequel les commutateurs (54b) contournent le courant autour d'une ou plusieurs parmi les cellules solaires.

3. Réseau de cellules solaires selon la revendication 1 ou 2, dans lequel les commutateurs (54b) sont commandés par un ou plusieurs signaux de commande.

4. Réseau de cellules solaires selon l'une quelconque des revendications 1 à 3, dans lequel les commutateurs (54b), lorsqu'ils sont fermés, connectent les contacts avant et arrière (32, 34) de la ou des cellules solaires (14), de sorte que le courant contourne la ou les cellules solaires.

5. Réseau de cellules solaires selon l'une quelconque des revendications 1 à 4, comprenant en outre un ou plusieurs commutateurs (54a) permettant d'ajouter ou de retirer une ou plusieurs cellules solaires d'une chaîne de cellules solaires.

6. Réseau de cellules solaires selon la revendication 5, dans lequel la longueur de la chaîne est modifiée pour changer la tension produite par la chaîne.

7. Réseau de cellules solaires selon l'une quelconque des revendications 1 à 6, dans lequel les connexions électriques comportent un ou plusieurs conducteurs (20) sur ou dans le substrat (12).

8. Réseau de cellules solaires selon l'une quelconque des revendications 1 à 7, dans lequel le substrat (12) comporte une ou plusieurs traces connectées aux commutateurs de dérivation (54b) permettant d'établir les connexions électriques entre les cellules solaires (14).

9. Procédé de fonctionnement d'un réseau de cellules solaires, le réseau de cellules solaires étant selon la revendication 1, le procédé comprenant :
la commande d'un ou plusieurs commutateurs (54b) dans une ou plusieurs connexions électriques à une ou plusieurs cellules solaires (14), afin de contourner une ou plusieurs connexions électriques à une ou plusieurs cellules solaires (14).

10. Procédé de fabrication d'un réseau de cellules solaires, le réseau de cellules solaires étant selon la revendication 1, le procédé comprenant :
la fixation d'une ou plusieurs cellules solaires (14) au substrat (12).

11. Procédé selon la revendication 10, dans lequel les commutateurs (54b) contournent le courant autour d'une ou plusieurs cellules solaires.

12. Procédé selon la revendication 10 ou 11, dans lequel les commutateurs (54b) sont commandés par un ou plusieurs signaux de commande.

13. Procédé selon l'une quelconque des revendications 10 à 12, dans lequel les commutateurs (54b), lorsqu'ils sont fermés, connectent les contacts avant et
arrière (32, 34) de la ou des cellules solaires (14), de sorte que le courant contourne la ou les cellules solaires.

14. Procédé selon l'une quelconque des revendications 10 à 13, dans lequel les connexions électriques comportent un ou plusieurs conducteurs (20) sur ou dans le substrat (12).

15. Procédé selon l'une quelconque des revendications 10 à 14, dans lequel le substrat (12) comporte une ou plusieurs traces connectées aux commutateurs de dérivation (54b) permettant d'établir les connexions électriques entre les cellules solaires (14).
